Europäisches Patentamt

(19) European Patent Office

Office européen des brevets

(11) EP 0 950 502 A2

(12) EUROPEAN PATENT APPLICATION

(43) Date of publication:
20.10.1999 Bulletin 1999/42

(51) Int. Cl.$^6$: **B29C 67/00**, B29C 33/38, B29C 70/68, G03C 9/08, G03C 1/00

(21) Application number: 99201177.5

(22) Date of filing: 15.04.1999

(84) Designated Contracting States:
AT BE CH CY DE DK ES FI FR GB GR IE IT LI LU MC NL PT SE
Designated Extension States:
AL LT LV MK RO SI

(30) Priority: 16.04.1998 JP 10618398

(71) Applicants:
• DSM N.V.
6411 TE Heerlen (NL)
• Japan Fine Coatings Co., Ltd.
Tokyo 104-8410 (JP)

• JSR Corporation
Tokyo 104-8410 (JP)

(72) Inventors:
• Ukachi, Takashi
Ushiku, 300-12 (JP)
• Yamamura, Tetsuya
Tsukuba, Ibaraki 305 (JP)

(74) Representative:
den Hartog, Jeroen Hendrikus Joseph et al
DSM Patents & Trademarks
Office Geleen
P.O. Box 9
6160 MA Geleen (NL)

(54) **Three-dimensional object including an integral structural member, resin mold and manufacturing process**

(57)     The present invention relates to a three-dimensional photofabrication object having a structural material therein. The object has high mechanical strenght, and can be used as a resin mold exhibiting high dimensional accuracy and excellent durability in repeated use. The invention also relates to a process for manufacturing three-dimensional objects which can easily fabricate three-dimensional objects having high mechanical strenght.

## Description

### Field of the Invention

The present invention relates to a three-dimensional object, a resin mold comprising said three-dimensional object, and a process for manufacturing the three-dimensional object by photofabrication.

### Background of the invention

In recent years, photofabrication of a three-dimensional object consisting of integrally laminated cured resin layers formed by repeating a step of forming said resin layer by selectively irradiating a photocurable material has been proposed (see Japanese Patent Application Laid-open No. 247515/1985, U.S. Patent No. 4,575,330 (Japanese Patent Application Laid-open No. 35966/1987), Japanese Patent Application Laid-open No. 101408/1987, Japanese Patent Application Laid-open No. 24119/1993). Such a photofabrication has attracted considerable attention because even a three-dimensional object having a complicated shape can be easily formed in a short period of time.

A typical example of the photofabrication is as follows. A cured resin layer is formed by selectively irradiating the surface of a thin liquid layer of a photocurable resin material, for example, with UV laser beams. The photocurable resin material equivalent to one layer is provided over this cured resin layer to form a thin layer. The surface of this thin layer is selectively irradiated to form another cured resin layer integrally laminated over the previously-formed cured resin layer. This step is repeated a certain number of times using the same or different irradiated patterns to obtain a three-dimensional object consisting of a number of integrally laminated cured resin layers.

In the photofabrication, characteristics required for the photocurable resin materials are low viscosity, high curability upon irradiation, capability of producing cured products exhibiting no, or only a small amount of, swelling when contacted by a photocurable resin material and exhibiting only minimal deformation such as warping, indentation, and overhanging of the stretched part (overhanging part) due to shrinkage during photocuring, as well as capability of forming the cured products with high dimensional accuracy to provide complicated and minutely-designed three-dimensional objects.

Three-dimensional objects obtained by the photofabrication have conventionally been used for design models, models for medical uses, master models for resin molds, and the like. Not only high dimensional accuracy, but also high mechanical strength and superior heat resistance under conditions of use are required for these three-dimensional objects. Photocurable resin materials for producing such three-dimensional objects have been proposed by Japanese Patent Applications Laid-open No. 213304/1989, No. 28261/1990, No. 59759/1996, and No. 278811/1997.

On the other hand, manufacturing of "molds" used for molding thermoplastic resins and fibrous materials by using various methods such as injection molding, press molding, vacuum molding, blow molding, and foam molding directly by photofabrication of a resin has been contemplated in recent years (see Japanese Patent Applications Laid-open No. 205157/1995, No. 276507/1995, No. 26062/1995, No. 316111/1997, and No. 316113/1997).

However, no conventional photofabrication methods can provide a photofabricated object satisfying various properties required for a resin mold, such as high dimensional accuracy, high mechanical strength, resistance to high pressure, superior heat resistance, and sufficient durability during repeated use. In particular, injection molding of engineering plastics is performed under the conditions of a high temperature and high pressure. No method for obtaining a photofabricated object (mold) capable of enduring such high temperature and high pressure conditions has been known. It has thus been difficult to produce a resin mold exhibiting high durability in repeated use under high temperature and high pressure conditions by the photofabrication of a resin.

The present invention has been achieved based on the above situation.

An object of the present invention is to provide a three-dimensional object having a high mechanical strength by photofabrication.

A second object of the present invention is to provide a resin mold exhibiting high dimensional accuracy and excellent durability in repeated use.

A third object of the present invention is to provide a process for manufacturing three-dimensional objects which can easily fabricate three-dimensional objects having a high mechanical strength.

### Summary of the Invention

The three-dimensional object of the present invention comprises a resin laminate consisting of many integrally laminated cured resin layers and at least one reinforcing or structural member (herein after referred to as "structural material") integrally laminated therein.

The three-dimensional object of the present invention may have the following structures:

(1) The resin laminate is formed on at least one side of the at least one structural material;

(2) The resin laminates are formed on each side of the at least one structural material; and

(3) The at least one structural material is embedded or surrounded by the resin laminate.

The resin mold of the present invention is made of the above-described three-dimensional object.

In the case where the three-dimensional object of the present invention has the structure wherein the resin laminate is formed on at least one side of the plate-like structural material, such a three-dimensional object can be manufactured by a process which comprises feeding a photocurable material to the surface of a horizontally placed plate-like structural material, selectively irradiating the photocurable material to produce a cured resin layer, and sequentially repeating these steps to obtain a resin laminate comprising a plurality of cured resin layers integrally laminated on the upper surface of the structural material.

When the three-dimensional object of the present invention has a structure wherein the resin laminates are formed on each side of the (prefebly plate-like) structural material, such a three-dimensional object can be manufactured by a process which comprises forming a first resin laminate comprising multiple cured resin layers by repeating steps of forming said resin layer by selectively irradiating a photocurable material, placing a plate-like structural material on the surface of the first resin laminate, feeding a photocurable material to the surface of the plate-like structural material, selectively irradiating the photocurable material to produce a cured resin layer, and sequentially repeating these steps to obtain a second resin laminate on the upper surface of the structural material.

When the three-dimensional object of the present invention has the structure wherein the structural material is embedded or surrounded (also referred to as "burried") in the resin laminate, such a three-dimensional object can be manufactured by a process which comprises forming an intermediate laminate comprising a plurality of cured resin layers with a concavity for receiving a structural material on the upper surface thereof by repeating steps of forming said resin layer by selectively irradiating a photocurable material, placing a structural material in the concavity for receiving the structural material of the intermediate laminate, feeding a photocurable material to the surfaces of said structural material and the intermediate laminate, selectively irradiating the photocurable resin material to produce a cured resin layer, and sequentially repeating these steps to obtain a resin laminate with said structural material buried.

In preferred embodiments of the present invention:

(1) The plate-like structural material has a thickness of 1 mm or more.

(2) The structural material is made of metals, inorganic materials, or resin materials having a specific gravity greater than that of the photocurable resin material formed thereon, a tensile strength and flexural strength greater than those of the resulting cured resin, and a thermal coefficient 0.01-100 times as large as that of the cured resin.

(3) The surface of the structural material with the resin laminate formed thereon is roughened to a coarseness of 0.01-0.5 mm.

(4) The surface of the structural material with the resin laminate formed thereon is treated with a primer.

(5) The surface of the structural material to form the resin laminate thereon is flat.

(6) The photocurable material is a photocurable resin composition comprising:

(A) a compound containing at least one cyclic structure selected from an epoxy ring or an oxetane ring;

(B) a cationic photopolymerization initiator;

(C) an ethylenically unsaturated monomer;

(D) a radical photopolymerization initiator; and

(E) an inorganic filler having an average particle diameter or an average fiber length of 1-50 $\mu$m.

(7) The cured resin layer is formed on a structural material with many through-holes or cavities formed therein after providing a cured resin layer on the surfaces of said through-holes or cavities.

(8) Projections are formed on the upper surface of a first resin laminate or the base of the concavity for placing the structural material of the intermediate laminate. A structural material with through-holes or cavities conforming to said projections formed thereon is placed on the upper surface of the first resin laminate or the concavity of said intermediate laminate, with said projections engaging with the through-holes of the structural material.

Brief Description of the Drawings

Figure 1 is a schematic diagram of an example of the three-dimensional object of the present invention.

Figure 2 is a schematic diagram of another example of the three-dimensional object of the present invention.

Figure 3 is a schematic diagram of a further example of the three-dimensional object of the present invention.

Figure 4 is a schematic diagram of the process for fabricating the three-dimensional object of Figure 1.

Figure 5 is a schematic diagram of the process for fabricating the three-dimensional object of Figure 2.

Figure 6 is a schematic diagram of the process for fabricating the three-dimensional object of Figure 3.

Figures 7 A and B are a side view and a plan view of the copper plate forming the structural material [A] used in the Examples.

Figures 8 A and B are a side view and a plan view of the stainless steel plate forming the structural material [B] used in the Examples.

Figure 9 is a schematic diagram of the structure of the core-type resin mold obtained in the Example 1.

Figure 10 is a schematic cross-sectional view of the process for fabricating the core-type resin mold of Figure 9.

Figure 11 is a schematic diagram of the structure of the core-type resin mold obtained in the Example 3.

Figure 12 is a schematic cross-sectional view of the process for fabricating the core-type resin mold of Figure 11.

Explanation of Symbols

1 Pin pattern
2 Rib
3 Pin pattern
4 Claw
5 Screw pit for securing
6 Pin pattern
10 Structural material
20 Resin laminate
20A First resin laminate
20B Second resin laminate
20C Intermediate laminate
K Through-hole
T Projection

Preferred Embodiments of the Invention

Preferred embodiments of the present invention will now be described in more detail.

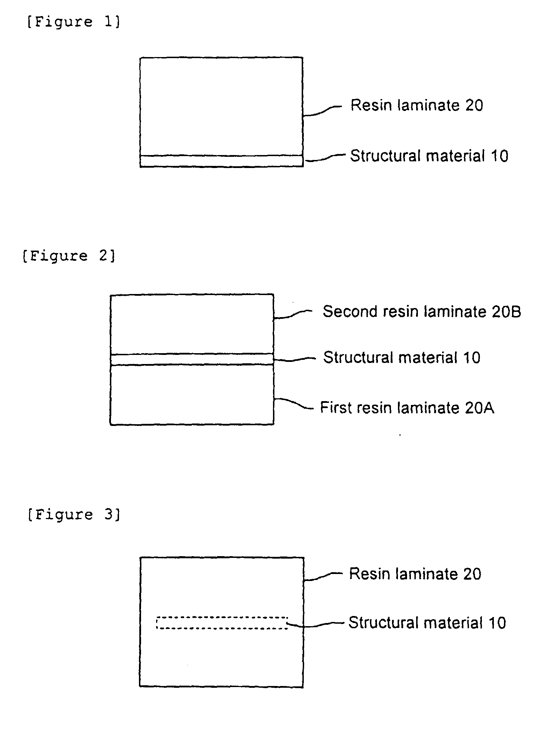

The three-dimensional object of the present invention comprises the resin laminate consisting of many integrally laminated cured resin layers and the structural material integrally laminated thereon. Specific examples of structures of such a three-dimensional object include: (1) a structure wherein a resin laminate 20 is integrally formed on a plate-like structural material 10 as shown in Figure 1, (2) a structure wherein a resin laminate 20A is integrally formed on the plate-like structural material 10 and a resin laminate 20B is integrally formed on the other side of the structural material 10 as shown in Figure 2, and (3) a structure wherein the structural material 10 is buried in the resin laminate 20 as shown in Figure 3. The structure of the three-dimensional object of the present invention, however, is not limited to these structures.

These three-dimensional objects can be formed by the following methods.

Method (1)

The three-dimensional object comprising the resin laminate integrally laminated on one side of the plate-like structural material can be formed as follows.

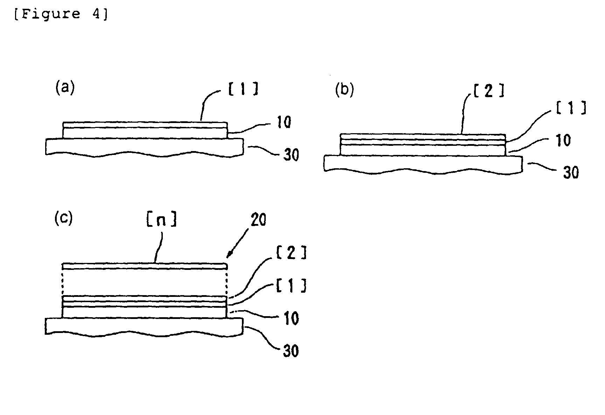

First, the plate-like structural material 10 is placed on an appropriate horizontal support stage 30, as shown in Figure 4 (a). The photocurable resin material is provided over the surface of the structural material 10 to form a thin layer. This thin layer is selectively irradiated to form a cured resin layer [1] integrally laminated on the surface of the structural material 10. The photocurable material is provided over the cured resin layer [1] to form a thin layer. This thin layer is selectively irradiated to form another cured resin layer [2] integrally laminated on the cured resin layer [1], as shown in Figure 4 (b). This step is repeated a specified number of times (specifically, (n - 1) times when the desired number of cured resin layers forming the resin laminate is n, provided that n is an integer of 2 or more) via the same or different irradiated patterns to form the resin laminate 20 consisting of the integrally laminated cured resin layers [1] through [n] on the upper surface of the structural material 10, as shown in Figure 4 (c). The three-dimensional object of Figure 1 is thus obtained.

Method (2)

The three-dimensional object comprising a first resin laminate 20A and a second resin laminate 20B laminated on either side of the plate-like structural material 10 can be formed as follows.

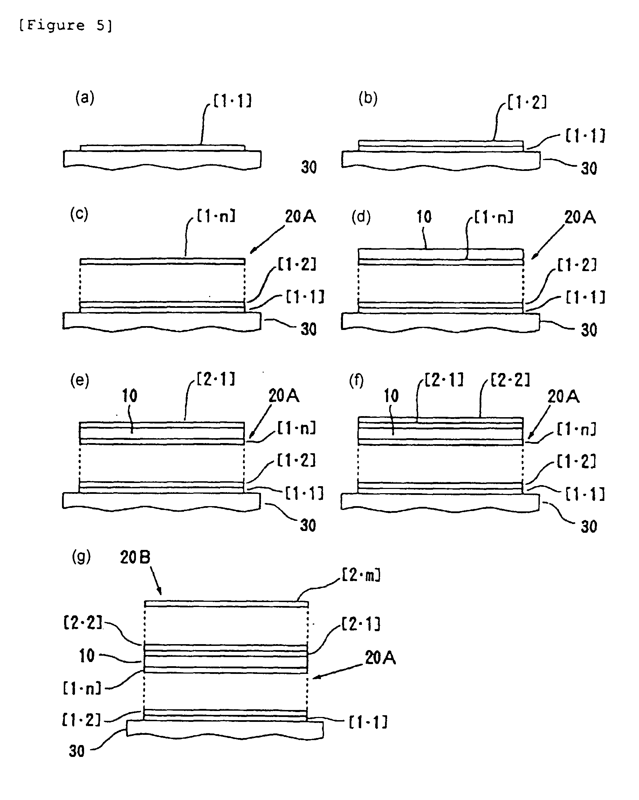

First, as shown in figure 5 (a), the photocurable material is provided on the appropriate horizontal support stage 30 to form a thin layer. This thin layer is selectively irradiated to form a cured resin layer [1 • 1] having a suitable shape. The photocurable material is provided over this cured resin layer [1 • 1] to form a thin layer. This thin layer is selectively irradiated to form another cured resin layer [1 • 2] integrally laminated on the cured resin layer [1 • 1], as shown in Figure 5 (b). This step is repeated (n - 1) times (n is the number of cured resin layers forming the first resin laminate) via the same or different irradiated patterns to form the first resin laminate 20A consisting of the integrally laminated cured resin layers [1 • 1] to [1 • n].

Secondly, as shown in Figure 5 (d), the structural material 10 is placed on the surface of the resin laminate 20A, specifically, the surface of the cured resin layer [1 • n]. After the photocurable material is provided over the surface of the structural material 10 to form a thin layer, the thin layer is selectively irradiated to form a cured resin layer [2 • 1], integrally laminated on the surface of the structural material 10, as shown in Figure 5 (e). The photocurable material is provided over this cured resin layer [2 • 1] to form a thin layer. This thin layer is selectively irradiated to form another cured resin layer [2 • 2], integrally laminated on the cured resin layer [2 • 1], as shown in Figure 5 (f). This step is repeated (m - 1) times (m is the number of cured resin layers forming the second resin laminate) via the same or different irradiated patterns to form the first resin laminate 20B consisting of the integrally laminated cured resin layers [2 • 1] to [2 • m]. The three-dimensional object of Figure 2 is thus obtained.

Method (3)

The three-dimensional object comprising the structural material 10 buried in the resin laminate 20, is formed by the following process.

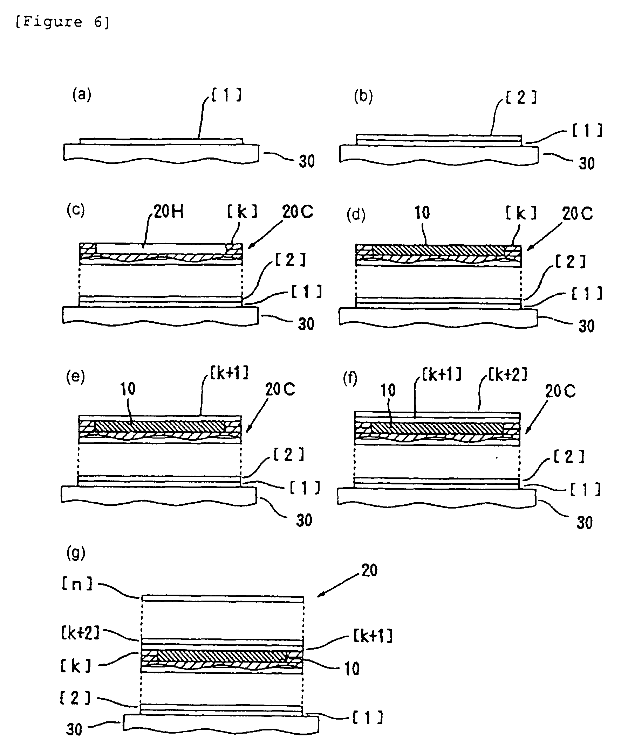

First, as shown in figure 6 (a), the photocurable material is provided on the appropriate horizontal support stage 30 to form a thin layer. This thin layer is selectively irradiated to form a cured resin layer [1] having a suitable shape. The photocurable material is provided over this cured resin layer [1] to form a thin layer. This thin layer is selectively irradiated to form another cured resin layer [2] integrally laminated on the cured resin layer [1], as shown in Figure 6 (b). This step is repeated (k - 1) times (k is the number of cured resin layers forming the intermediate laminate) via the same or different irradiated patterns to form an intermediate laminate 20C consisting of many integrally laminated cured resin layers [1]through[k], preferably with a concavity 20H for setting the structural material formed thereon as shown in figure 6 (c).

Secondly, as shown in figure 6 (d), the structural material 10 is placed on or in the concavity 20H of the intermediate laminate 20C. When there is a concavity the upper surface of the structural material 10 is substantially even with the surface of the cured resin layer [k] of the intermediate laminate 20C. The photocurable material is then provided over the surfaces of the structural material 10 and the cured resin layer [k] to form a thin layer. This thin layer is selectively irradiated to form a cured resin layer [k + 1] integrally laminated on the surfaces of the structural material 10 and the cured resin layer [k] as shown in Figure 6 (e). The photocurable material is provided over the surface of this cured resin layer [k + 1] to form a thin layer. This thin layer is selectively irradiated to form a cured resin layer [k + 2] integrally laminated on the cured resin layer [k + 1] as shown in Figure 6 (f). This step is repeated (n - (k + 1)) times (n is the number of cured resin layers constituting the resin laminate) via the same or different irradiated patterns to form an intermediate laminate consisting of many integrally laminated cured resin layers [1 • 1]-[1 • m] with the structural material 10 buried therein, as shown in Figure 6 (g). The three-dimensional object of Figure 3 is thus obtained.

In the above methods (1)through(3), when a structural material 10 with through-holes or cavities formed therein is used, it is possible to place this structural material 10 first, form a cured resin layer over the through-holes or cavities of the structural material 10, and then form subsequent cured resin layers (specifically, cured resin layer [1], cured resin layer [2 • 1], or cured resin layer [k + 1]). In this case, it is preferable that the side of the through-holes in the structural material 10 be provided with concavities or grooves.

In the methods 2 and 3, the following process can be included: forming, for example, multiple cylindrical projections on the surface of the first resin laminate 20A or the base of the concavity 20H of the intermediate laminate 20C; using a structural material 10 with through-holes or cavities having internal diameters as large as or larger than the outside diameters of these projections formed in locations corresponding to these projections; and placing said structural material 10 on the surface of the resin laminate 20A or in the concavity 20H of the intermediate laminate 20C while engaging the projections of the resin laminate 20A or the intermediate laminate 20C with the through-holes of this structural material 10. In this case, the height of the projections of the resin laminate 20A or the intermediate laminate 20C is preferably equivalent to the depth of the through-holes or the cavities of the structural material 10.

In the present invention, there are no specific limitations to the means of selectively irradiating the photocurable material. For example, the following means (i) through (iii) can be employed: (i) irradiating a photocurable material while scanning with laser beams or focused rays converged by lenses, mirrors, and the like; (ii) irradiating a photocurable material with unfocused rays via a mask having a phototransmission portion with a specified pattern; and (iii) irradiating a photocurable material by using an optical transparent material consisting of bundled multiple optical fibers, wherein the photocurable material is irradiated via specific optical fibers corresponding to the specified pattern of the photo-conductive material. In the above means using a mask, a mask which electrooptically forms a mask image consisting of a photo-transmission area and a non-phototransmission area according to a specified pattern by the same concept as that of a liquid crystal display can be used. If microfabrication or a higher dimensional accuracy is required for the objective three-dimensional object, it is preferable to employ the means of scanning with laser beams as the means of selectively irradiating the photocurable material.

After removal of the unreacted photocurable material remaining on the surface of the resulting three-dimensional object, the object is optionally rinsed. In this rinsing step, organic solvents represented by alcohols such as isopropyl alcohol and ethyl alcohol, esters such as ethyl acetate, ketones such as acetone and methyl ethyl ketone; aliphatic organic solvents represented by terpenes and glycol esters; and low viscosity thermosetting materials and photocurable materials can be used as rinsing agents.

If a smooth surface is required for the objective three-dimensional object, after the above rinsing step, postcuring by heat or photoradiation is preferably carried out according to type of the photocurable material. In particular, if the photocurable material cannot be cured by photoradiation because the uncured photocurable resin material is trapped in the concavities or grooves of the surface of the structural material 10, such a photocurable material can be postcured by heat. In addition, since not only the photocurable materials on the surface of the object but also the unreacted materials remaining inside the three-dimensional objects can be cured by this postcuring process, it is also preferable to carry out the postcuring after rinsing the objects with organic solvents.

Furthermore, in order to improve the surface hardness and heat resistance of the three-dimensional objects, it is preferable to coat the surface of the objects with a heat-curable or photocurable hard coating material after rinsing the object. Examples of the hard coatings include organic coatings such as an acrylic resin, epoxy resin, silicone resin, fluoro resin, and various inorganic coating materials. Combinations of two or more hard coatings are also acceptable.

In the present invention, the structural material having a flat surface on which cured resin layers are formed is preferred. This ensures forming a thin layer of a photocurable material with a uniform thickness on the surface of said material, whereby a uniformly cured resin layer can be obtained. If the surface of the structural material is not flat, it is difficult to form a thin layer of the photocurable material with a uniform thickness, which results in cured resin layers with uneven degrees of curing.

When a plate-like structural material is used, the thickness of such a material is preferably 1 mm or more. If the thickness of the structural material is less than 1 mm, handling of said structural material might be difficult. Moreover, desired mechanical strength cannot be provided for the three-dimensional object.

When a plate-like structural material is used, the plate preferably has at least one, and more preferably at least two holes. The at least one hole allows precise positioning and strengthens the cured resin part.

Preferably, the plate-like structural element covers at least 40% of the area of the total cross section of the article; it is more preferred, to cover at least 60% of the area. Generally, the area will be less than 90%, but this is not critical.

Materials such as metals, inorganic materials, resin materials, and wood can be used as the structural material. Specific examples of such materials are given below.

Specific examples of such metals include metals and alloys such as iron, copper, aluminum, zinc alloy, brass, stainless steel, carbon steel, high strength steel, heat resistant steel, cast iron, and blister steel.

Specific examples of such inorganic materials include minerals such as marble, granite, and calcite, amorphous materials such as glass, brick, cement, graphite, asphalt, and alumina, inorganic fibers such as woven and nonwoven fabric made from asbestos, woven and nonwoven fabric made from glass wool, woven and nonwoven fabric made from carbon fiber, and the like.

Specific examples of such resin materials include thermoplastic resins such as polypropylene, polyethylene, polystyrene, polyamide, acrylonitrile-butadiene-styrene copolymer, acrylonitrile-styrene copolymer, polyether sulfone, polycarbonate, polymethyl methacrylate, polyaryl sulfonate, polybuthyleneterephthalate, polyether ether ketone, and polyoxymethylene, thermosetting resins such as polyepoxide, polyimide, phenol resin, urea resin, xylene resin, xyleneformaldehyde resin, diarylphthalate resin, unsaturated polyester resin, melamine resin, and resorcinol resin.

Specific examples of wood include evergreen oak, Japanese hemlock, hemlock, cedar, paulownia, pine, lauan, and plywoods made of these woods, and the like.

Moreover, the structural material is preferably made from materials having a specific gravity greater than that of the photocurable material, a tensile strength or flexural strength higher than that of the resulting cured resin, and a coefficient of linear thermal expansion 0.01-100 times as large as that of the cured resin. In particular, the coefficient of linear thermal expansion of such materials is more preferably 0.05-20 times, even more preferably 0.1-10 times, as large as that of the cured resin.

If the structural material having a specific gravity smaller than that of the photocurable material is used, the structural material cannot be adequately placed on the specified position due to the buoyancy of the photocurable material.

If the structural material having a tensile strength or flexural strength equal to or lower than that of the cured resin is used, a considerable thickness is needed for forming the structural material to obtain the three-dimensional object exhibiting the desired mechanical strength. As a result, the resulting three-dimensional object becomes large, whereby handling of the three-dimensional object may be difficult depending on the application.

Use of a structural material having a coefficient of linear thermal expansion less than 0.01 or greater than 100 times that of the cured resin causes distortion on the boundary surface between the structural material and the resin laminate. This is due to the coefficient difference of the linear thermal expansion when the resulting three-dimensional object is used at a high temperature. Consequently, the three-dimensional object may break.

The surface of the structural material with the resin laminate formed thereon is preferably roughened to a coarseness of 0.01-0.5 mm. This ensures the forming of a three-dimensional object with the structural material firmly adhering to the resin laminate. Machining and sanding are given as examples of the means for roughening the surface of the structural material. If the structural material is made of a resin material, the surface of such a structural material can be roughened by treating with a solvent which is capable of dissolving or swelling the resin material.

If the coarseness of the surface of the structural material is less than 0.01 mm, the structural material may exhibit insufficient adhesion to the resin laminate. On the other hand, if the coarseness exceeds 0.5 mm, a cured resin layer formed thereon may exhibit insufficient curing.

The surface of the structural material with the resin laminate formed thereon is preferably treated with a primer, whereby the structural material of the resulting three-dimensional object firmly adheres to the resin laminate.

Any suitable primer can be used insofar as curing of the photocurable material is not inhibited. Specific examples of such primers include an epoxy resin, urethane resin, melamine resin, formaldehyde resin, primers in which these resins are dissolved in an appropriate solvent, and the like.

In addition, coupling agents such as silane coupling agents, titanium coupling agents, and aluminum coupling agents can be used as the primer.

Specific examples of silane coupling agents include vinyltrichlorosilane, vinyltris($\beta$-methoxyethoxy)silane, vinyltriethoxysilane, vinyltrimethoxysilane, $\gamma$ - (methacryloxypropyl)trimethoxysilane, $\beta$ - (3,4-epoxycyclohexyl)ethyltrimethoxysilane, $\gamma$ - glycidoxypropyltrimethoxysilane, $\gamma$ - glycidoxypropylmethyldiethoxysilane, N-$\beta$-(aminoethyl)- $\gamma$ -aminopropyltrimethoxysilane, N-$\beta$-(aminoethyl)- $\gamma$ -aminopropylmethyldimethoxysilane, $\gamma$ - aminopropyltriethoxysilane, N-phenyl- $\gamma$ -aminopropyltrimethoxysilane, $\gamma$ - mercaptopropyltrimethoxysilane, $\gamma$ - chloropropyltrimethoxysilane, and the like. Specific examples of titanium coupling agents include isopropyltriiso-stearoyl titanate, isopropyltri-n-dodecylbensenesulfonyl titanate, isopropyltris(dioctylpyrophosphate) titanate, tetraisopropylbis(dioctylphosphite) titanate, tetraoctylbis(ditridecylphosphite) titanate, tetra(2,2-diallyloxymethyl-1-butyl)bis(di-tridecyl)phosphite titanate, bis(dioctylpyrophosphate)oxyacetate titanate, bis(dioctylpyrophosphate)ethylene titanate, isopropyltrioctanoyl titanate, isopropyldimethacrylisostearoyl titanate, isopropylisostearoyldiacryl titanate, isopropyltri(dioctylphosphate) titanate, isopropyltricumilphenyl titanate, isopropyltri(N-aminoethyl-aminoethyl) titanate, and the like.

Specific examples of aluminum coupling agents include acetoalkoxylaluminum diisopropylate, and the like.

The structural material is primed by immersing the structural material in a primer solution prepared by dissolving the above primers in a suitable organic solvent, removing this structural material from the primer solution, and optionally drying the solvent. Moreover, the primer or the primer solution can be applied to the structural material by using a roll coater or the like.

In the present invention, it is preferable to use a photocurable resin composition comprising: (A) a compound containing at least one cyclic structure selected from an epoxy ring or an oxetane ring (hereinafter also called "component (A)"), (B) a cationic photopolymerization initiator (hereinafter also called "component (B)"), (C) an ethylenically unsaturated monomer (hereinafter also called "component (C)"), (D) a radical photopolymerization initiator (hereinafter also called "component (D)"), and (E) an inorganic filler having an average particle diameter or an average fiber length of 1-50 $\mu$m (hereinafter also called "component (E)").

Component (A)

The compound having an epoxy ring used as the component (A) is a cationically polymerizable organic compound which polymerises or crosslinks by irradiation in the presence of cationic photopolymerization initiators.

Examples of the compound having an epoxy ring include compounds having a cyclohexene oxide structure, compounds having a glycidyl ether structure, diglycidyl esters of aliphatic long-chain dibasic acids, glycidyl esters of higher fatty acids, and the like. As specific examples of such compounds, compounds disclosed in Japanese Patent Application Laid-open No. 278811/1997 can be given. Of these, the compounds having a cyclohexene oxide structure are preferable.

As specific examples of compounds having an oxetane ring used as the component (A), compounds disclosed in Japanese Patent Application No. 352893/1996 can be given.

These compounds having an oxetane ring can be used either singly or in combinations of two or more.

More preferred examples of compounds having an epoxy ring used as the component (A) include epoxy compounds having two or more alicyclic epoxy groups in a molecule such as 3,4-epoxycyclohexylmethyl-3',4'-epoxycyclohexanecarboxylate and bis(3,4-epoxycyclohexylmethyl)adipate. More preferred examples of compounds having an oxetane ring used as the component (A) include (3-ethyl-3-oxetanylmethoxy)methylbenzene, 1,4-bis[(3-ethyl-3-oxetanylmethoxy)methyl]benzene, 1,2-bis(3-ethyl-3-oxetanylmethoxy)ethane, trimethylolpropanetris(3-ethyl-3-oxetanylmethyl) ether, and the like.

If these epoxy compounds or oxetane compounds are used in the proportion of 50-100 wt% in the component (A), the resulting photocurable resin composition exhibits a high cationic polymerization rate (curing speed), whereby fabrication time can be reduced. Moreover, deformation with time of the three-dimensional object can be controlled owing to the smaller cure shrinkage.

The proportion of the component (A) used in the photocurable resin composition is usually 5-60 wt%, preferably 10-50 wt%, and more preferably 15-40 wt%. If the proportion of the component (A) is too small, photocurability of the resulting photocurable resin composition may be low, thereby causing inefficient fabrication. On the other hand, if the proportion of the component (A) is too large, toughness as well as durability as a mold of the resulting three-dimensional object tend to decrease .

Component (B)

The cationic photopolymerization initiator used as the component (B) is a compound capable of evolving a material which initiates cationic polymerization of the component (A) upon exposure to energy rays such as light.

As such a cationic photopolymerization initiator, compounds evolving Lewis acids upon exposure to light are preferable. As specific examples of these compounds, onium salts disclosed in Japanese Patent Application Laid-open 278811/1997 and the like can be given.

Of these onium salts, UVI-6970, UVI-6974, Adekaoptomer SP-170, SP-171, CD-1012, MPI-103 are preferable since the photocurable resin composition, containing such compounds, exhibit high cure sensitivity.

The proportion of the component (B) used in the photocurable resin composition is usually 0.1-10 wt%, preferably 0.2-5 wt%, and more preferably 0.3-3 wt%. If the proportion of the component (B) is too small, the resulting photocurable resin composition may exhibit low photocurability, which may result in insufficient mechanical strength of the three-dimensional object. On the other hand, if the proportion is too large, a thin layer having an appropriate phototransmission (cure depth) cannot be formed from the composition when forming a cured resin layer, thereby causing low mechanical strength, for example, toughness of the resulting three-dimensional object.

Component (C)

The ethylenically unsaturated monomer used as the component (C) is a compound having an ethylenically unsaturated bond (C=C) in a molecule. Examples of such a compound include monofunctional monomers having one ethylenically unsaturated bond in a molecule, polyfunctional monomers having two or more ethylenically unsaturated bonds in a molecule, and the like. As specific examples of these monofunctional and polyfunctional monomers, compounds disclosed in Japanese Patent Application Laid-open No. 278811/1997 can be given.

The above monofunctional and polyfunctional monomers can be used either singly or in combinations of two or more as the component (C). In the present invention, use of polyfunctional monomers having more than three functional groups, specifically, monomers having more than three ethylenically unsaturated bonds in a molecule as part or all of the component (C) is preferred. The proportion of such polyfunctional monomers having three or more functional groups in the component (C) is preferably 60 wt% or more, more preferably 80 wt% or more, and even more preferably 100 wt%. If this proportion is less than 60 wt%, the resulting photocurable resin composition exhibits insufficient photocurability. In addition, the three-dimensional object tends to exhibit deformation with time.

The proportion of the component (C) used in the photocurable resin composition is usually 1-30 wt%, preferably 2- 20 wt%, and more preferably 3-15 wt%. If the proportion is too small, the resulting photocurable resin composition exhibits inferior photocurability and the three-dimensional object exhibit insufficient mechanical strength. On the other hand, if the proportion is too large, the resulting photocurable resin composition exhibits shrinkage during photocuring and the resulting three-dimensional object tends to exhibit decreased mechanical strength such as reduced tenacity.

Component (D)

The radical photopolymerization initiator used as the component (D) is a compound which decomposes and evolves radicals to initiate radical polymerization of the component (C) upon exposure to energy rays such as light. As specific examples of such a radical photopolymerization initiator, compounds disclosed in Japanese Patent Application Laid-open No. 278811/1997 can be given.

Of these compounds, benzyl dimethyl ketal, 1-hydroxycyclohexylphenyl ketone, 2,4,6-trimethylbenzoyldiphenylphosphine oxide, 2-benzyl-2-dimethylamino-1-(4-morpholinophenyl)-butan-1-one, and the like are preferred.

The proportion of the component (D) used in the photocurable resin composition is usually 0.01-8 wt%, and preferably 0.1-5 wt%. If the proportion is too small, the resulting photocurable resin composition exhibits a low radical polymerization rate (curing speed), thereby resulting in a longer fabrication time or a lower resolution of images produced from the composition. On the other hand, if the proportion is too large, curing characteristics of the photocurable resin composition, physical properties, heat resistance, handling, and the like of the three-dimensional object are adversely affected by an excess amount of the photopolymerization initiator.

Component (E)

The inorganic filler used as the component (E) improves the mechanical characteristics and heat resistance of the cured products without impairing photocurability and fabricability of the photocurable resin composition. Moreover, the component (E) improves durability when the resulting three-dimensional object is used as a resin mold.

As such an inorganic filler, particle-type inorganic fillers and fiber-type inorganic fillers having an average particle diameter or an average fiber length of 1-50 $\mu$m can be used without specific limitations. In the present invention, spherical silica particles are preferred.

Use of spherical silica particles as the inorganic filler provides the cured products of the photocurable resin composition with superior mechanical characteristics and heat resistance. Moreover, the spherical shape of such silica particles improves the fluidity of the photocurable resin composition, whereby flat and smooth laminated layers can be formed at the time of photofabrication and the uncured resin do not remain inside the fabricated object, unlike using particles having free forms. Accordingly, use of the photocurable resin composition containing spherical silica particles ensures higher dimensional accuracy and superior durability of the resulting three-dimensional object.

In the present invention, "spherical silica particles" means silica particles having an average value of degree of sphericity (hereinafter called "average degree of sphericity") of 0.9 or more. Here, the degree of sphericity is also designated as sphericity, which is defined by the following formula:

$$\text{Degree of Sphericity} = \frac{\sqrt{4\pi S_p}}{C} = \frac{d_{pa}}{d_{pc}}$$

wherein Sp is a projected area of particles, c is the circumference of a projected image of particles, $d_{pa}$ is the diameter of a circle having the same area as the projected area (Sp) of the particles, and $d_{pc}$ is the diameter of a circle having a circumference with the same length as the circumference (c) of the projected image of particles.

The deviations from spherical form can be measured by analyzing an electron micrograph pictured by a scanning electron microscope (SEM) by using an image analysis apparatus. The average degree of sphericity can be calculated by determining the average value of the deviations from spherical form of, for example, 100 particles selected arbitrary from the SEM pictures.

The average deviation from spherical form of the silica particles used as the component (E) is preferably 0.90 or more, and more preferably 0.92 or more.

As examples of such spherical silica particles, silica particles having silicon oxide as the principal component which contain a small amount of impurities such as alkali metal can be given.

The average particle diameter of spherical silica particles is 1-50 $\mu$m, and preferably 2-30 $\mu$m. If this average particle diameter is too small, the resin composition exhibits increased viscosity and the cured products exhibit insufficient dimensional accuracy. On the other hand, if the average particle diameter is too large, cured products having a flat and smooth surface cannot be obtained from the resin composition.

Examples of commercially available products of spherical silica particles include Sunsphere NP-100, NP-200 (manufactured by Tokai Chemical Industries Co., Ltd.), Silstar MK-08, MK-15 (manufactured by Nippon Chemical Industries Co., Ltd.), FB-48 (manufactured by Denki Kagaku Kogyo Co., Ltd.), and the like.

Inorganic fillers other than spherical silica particles can be also used as the component (E). Specific examples of such inorganic fillers include glass powder, glass beads, hollow glass beads, silica powder, alumina, alumina hydrate, magnesium oxide, magnesium hydroxide, barium sulfate, calcium sulfate, calcium carbonate, magnesium carbonate, mineral silicate, diatomite, silica sand, silica rock powder, titanium oxide, aluminum powder, bronze, zinc powder, copper powder, lead powder, gold powder, silver powder, glass fiber, potassium titanate whisker, carbon whisker, sapphire whisker, beryllium whisker, boron carbide whisker, silicon carbide whisker, silicon nitride whisker, and the like. Of these, glass beads, hollow glass beads, potassium titanate whisker, and the like are preferable. These inorganic fillers can be used singly or in combinations of two or more.

Inorganic fillers disclosed in Japanese Patent Applications Laid-open No. 87810/1998, No. 26060/1995, and No. 26062/1995 can be given as examples of such inorganic fillers.

The surface of the inorganic filler used as the component (E) may be treated with silane coupling agents. As specific examples of such silane coupling agents, silane coupling agents exemplified as the primer used for the structural material can be given.

The proportion of the component (E) used in the photocurable resin composition is 100-160 parts by volume, and preferably 120-155 parts by volume, for 100 parts by volume of the components (A) through (C). Here, the "volume of the inorganic filler" is a value determined by dividing the weight (w) by the true specific gravity (d) of the inorganic filler (w/d).

Optional components

In the photocurable resin composition, components other than the above-described (A) through (E) can be used inasmuch as photocurability is not impaired.

Examples of such optional components include: photosensitizers (polymerization accelerator) consisting of amine compounds such as triethanolamine, methyl diethanolamine, triethylamine, and diethylamine; photosensitizer consisting of thioxanethone, derivatives of thioxanethone, anthraquinone, derivatives of anthraquinone, anthracene, derivatives of anthracene, perylene, derivatives of perylene, benzophenone, benzoin isopropyl ether, and the like; and reactive diluents such as vinyl ethers, vinyl sulfides, vinyl urethans, urethane acrylates, vinyl ureas can be given.

Examples of other optional components include polymers or oligomers such as epoxy resin (cured product), polyamide, polyamideimide, polyurethane, polybutadiene, polychloroprene, polyether, polyester, styrene-butadiene-styrene block copolymer, petroleum resin, xylene resin, ketone resin, cellulose resin, fluorine-containing oligomer, silicone oligomer, polysulfide oligomer, polymerization inhibitors such as phenothiazine and 2,6-di-t-butyl-4-methylphenol, polymerization adjuvants, aging preventives, leveling agents, wettability improvers, surfactants, plasticizers, UV stabilizers, UV absorbers, silane coupling agents, pigments, dyes, and the like.

In addition, organic fillers can be used as optional components. As examples of such organic fillers, organic solid fine particles consisting of crosslinking polystyrene polymers, crosslinking polymethacrylate polymers, polyethylene polymers, and polypropylene polymers and the like can be given.

The photocurable resin composition can be prepared by homogeneously mixing the above components (A) through (E) with optional components, as required.

Viscosity of the resulting photocurable resin composition at 25°C is preferably 500-40,000 cps, and more preferably 1,000-30,000 cps.

If the viscosity (25°C) of the resulting photocurable resin composition is lower than 500 cps, dispersion of the inorganic filler in the fabricated object becomes uneven due to the high precipitation rate of the inorganic filler, thereby resulting in insufficient mechanical strength of the three-dimensional object. On the other hand, if the viscosity (25°C) of the photocurable resin composition exceeds 40,000 cps, the resulting cured products exhibit an uneven surface, whereby the three-dimensional object having high dimensional accuracy cannot be obtained.

In the present invention, materials other than the above-described photocurable resin composition, for example, urethan photocurable resins, acrylic photocurable resins, epoxy photocurable resins, vinyl ether photocurable resins, mixtures of these resins, compositions prepared by mixing these resins and particle-type or fiber-type inorganic or organic fillers can be used as the photocurable material. Specific examples of such photocurable materials are disclosed in Japanese Patent Applications Laid-open No.278811/1997, No. 316111/1997, No. 315113/1997, No. 41147/1996, No. 145616/1990, No. 100835/1992, No. 85314/1992, No. 213304/1989, No. 28261/1990, No. 210364/1991, No. 188382/1995, No. 199962/1994, No. 322039/1994, No. 26060/1995, No. 26062/1995, No. 15520/1991, No. 114732/1991, No. 114733/1991, No. 322039/1994, 168165/1998, No. 329303/1998, No. 329304/1998, No. 87810/1998, No. 270868/1998, and in Japanese Patent Applications No. 52729/1998, No. 58861/1998, and No. 58862/1998.

The three-dimensional object thus obtained exhibits high mechanical strength, superior durability at a high temperature, and high dimensional accuracy. Accordingly, said three-dimensional object is suitable as resin molds used for various moldings such as an injection molding, press molding, vacuum molding, air-pressure molding, foam molding, and pulp molding.

Examples

The present invention will now be described by Examples, which should not be construed as limiting the present invention.

Preparation of photocurable material

Preparation Example 1

A reaction vessel equipped with a stirrer was charged with 23 parts by weight of 3,4-epoxycyclohexylmethyl-3,4-epoxycyclohexane carboxylate "UVR6110" (manufactured by Union Carbide Corp.) (Component (A)), 1 part by weight of bis[4-(diphenylsulfonio)phenyl]sulfidebishexafluoro antimonate (component (B)), 4 parts by weight of trimethylolpropane triacrylate "Viscoat 295" (manufactured by Osaka Organic Chemical Industry Co., Ltd.) and 2 parts by weight of dipentaerythritol hexaacrylate "KAYARAD DPHA" (manufactured by Nippon Kayaku Co., Ltd.) (Component (C)), 1 part by weight of 1-hydroxycyclohexylphenyl ketone "Irgacure 184" (manufactured by Ciba Specialty Chemicals Co., Ltd.) (Component (D)), and 8.5 parts by weight of butanediol diglycidyl ether "Araldite DY-022" (manufactured by Ciba Geigy) and 0.5 parts by weight of epoxy-type silane coupling agent "S-530" (manufactured by Chisso Corp.) as optional components. The mixture was stirred for two hours at 50°C to obtain a homogeneous resin liquid. After the addition of 60 parts by weight of spherical silica particles (average deviation from spherical form: 0.97, average particle diameter: 10 µm) (component (E)), the mixture was stirred in a reaction vessel equipped with a high-speed stirrer (rotational speed: 3000 rpm) for 10 minutes at room temperature to prepare a photocurable material [1]. This photocurable material [1] was a homogeneous opaque viscous liquid.

Preparation Example 2

A reaction vessel equipped with a stirrer was charged with 29 parts by weight of 1,4-bis[(3-ethyl-3-oxetanylmethoxy)methyl]benzene and 10 parts by weight of epoxy-modified polybutadiene "Epolead PB3600" (Component (A)), 1 part by weight of "UVI-6974" (manufactured by Union Carbide Corp.) (Component (B)), 6 parts by weight of trimethylolpropane triacrylate (Component (C)), and 1 part by weight of 1-hydroxycyclohexylphenyl ketone (Component (D)). The mixture was stirred for one hour at 50°C to obtain a transparent resin liquid. After the addition of 54 parts by weight of spherical silica particles (average deviation from spherical form: 0.97, average particle diameter: 10 m) (Component (E)), the mixture was stirred in the same manner as in Preparation Example 1 to prepare a photocurable material [2]. This photocurable material [2] was a homogeneous opaque viscous liquid.

Preparation Example 3

A reaction vessel equipped with a stirrer was charged with tricyclodecanediyldimethylene diacrylate (100 g), 2,4-tolylene diisocyanate (171.4 g), dibutyltin laurate (1.56 g), and 2,6-di-t-butyl-4-methylphenol (0.65 g). The mixture was stirred at 25°C or below while gradually adding 2-hydroxyethyl acrylate (114.3 g). After the addition, the mixture was stirred while maintaining the reaction system at 15-35°C for one hour to effect an urethanization reaction. 2-Hydroxyethyl acrylate (114.3 g) was gradually added for six hours while stirring at 50-60°C to continue the urethanization reaction. A reaction product was then removed when the residual isocyanate group was confirmed to be 0.1% or less. The number average molecular weight of polyfunctional acrylate (hereinafter referred to as "polyfunctional acrylate (1)") in this reaction product was 406. The weight ratio of the polyfunctional acrylate (1) to tricyclodecanediyldimethylene diacrylate in the reaction product was 40:10.

The reaction vessel was charged with 15 parts by weight of the above reaction product containing the polyfunctional acrylate (1) and tricyclodecanediyldimethylene diacrylate (weight ratio: 40:10), 7 parts by weight of tricyclo[5.2.1.0$^{2,6}$]decanyl acrylate (glass transition temperature of homopolymer: 120°C), 7 parts by weight of N-vinylpyrrolidone (glass transition temperature of homopolymer: 170°C), 1 part by weight of 1-hydroxycyclohexylphenyl ketone, and 0.1 parts by weight of p-methoxyphenol. The mixture was stirred for two hours at 50°C), to obtain a transparent liquid mixture. After the addition of 69.9 parts by weight of glass beads "GB045ZC" (manufactured by Toshiba-Ballotini Co., Ltd., average particles diameter: 17 µm, true specific gravity: 2.5), the mixture was stirred by using a homomixer to prepare a homogeneous slurry photocurable material [3]. This photocurable material [3] was gray.

Preparation of structural material

Preparation Example 1

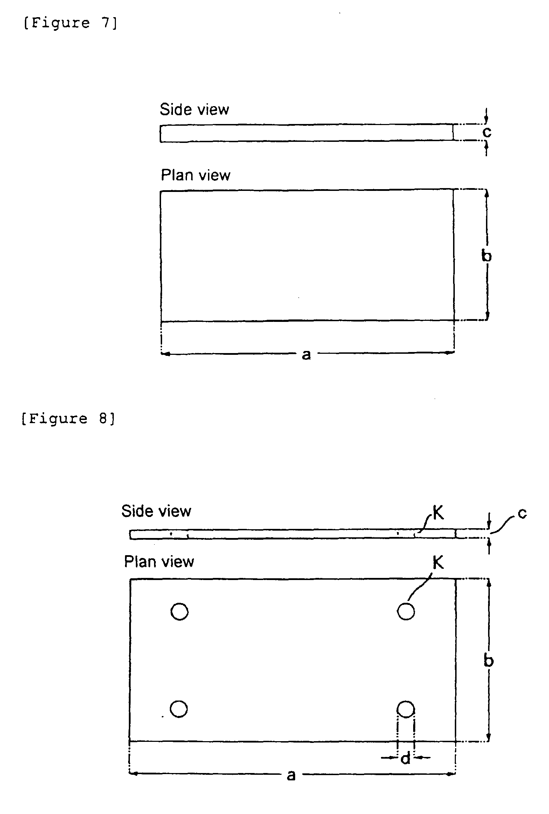

A copper plate (length (a): 180 mm, width (b): 80 mm, thickness (c): 10 mm) as shown in Figure 7 was prepared. The surface of this copper plate was roughened to a coarseness of 0.05 mm by using a sand blaster. The surface of the copper plate was treated with a primer in which 5 parts by weight of epoxy-type silane coupling agent ("S-530", manufactured by Chisso Corp.) was dissolved in 95 parts by weight of methyl ethyl ketone. After drying at room temperature, a structural material [A] was obtained.

Preparation Example 2

A stainless steel plate as shown in Figure 8 (length (a): 200 mm, width (b): 100 mm, thickness (c): 5 mm) with four through-holes having a diameter (d) of 10 mm formed therein was prepared. The surface of this stainless steel plate was roughened and treated with a primer in the same manner as in the Example 1 to obtain a structural material [B].

Example 1

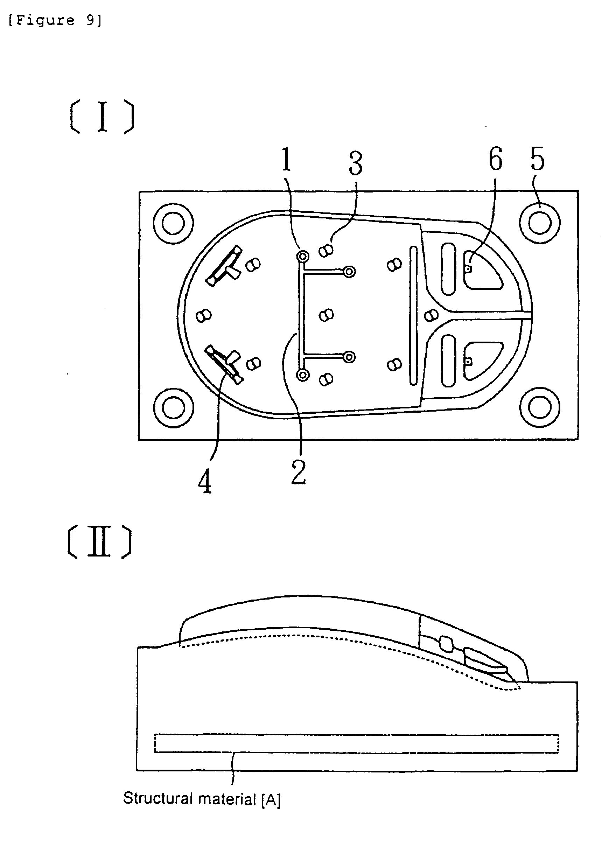

Cavity-type and core-type resin molds were fabricated from the photocurable material [1] and the structural material [A] by using a photofabrication apparatus "Solid Creator JSC-2000" (manufactured by Sony Corporation) equipped with an argon ion laser (wavelength: 351 nm and 364 nm) as a light source (laser light intensity at liquid surface: 40 mW, scanning speed: 100 cm/second, thickness of cured resin layer: 0.2 mm) by a process described below. Figure 9 is a plan view (I) and a side view (II) of the core-type three-dimensional object. In Figure 9, 1 is a pin pattern, 2 a rib, 3 a pin pattern, 4 a claw, 5 a screw pit for securing, and 6 a pin pattern.

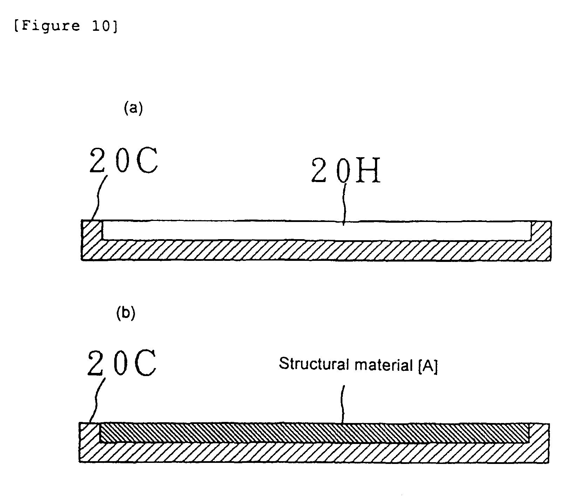

(1) As shown in Figure 10, an intermediate laminate 20C (length: 200 mm, width: 100 mm, height: 20 mm) with a concavity 20H for receiving the structural material (length: 180 mm, width: 80 mm, depth: 10 mm) formed therein was fabricated (number of laminated layers of intermediate laminate: 100). The concavity 20H was filled with the photocurable material [1].
(2) The structural material [A] was placed in the concavity 20H in the intermediate laminate 20C to cause to the photocurable material [1] overflow from the concavity 20H. Here, the surface of the structural material [A] is substantially even with the surface of the intermediate laminate 20C.
(3) The step of forming a cured resin layer from the photocurable material [1] on the upper surfaces of the structural material [A] and the intermediate laminate 20C was repeated 350 times to form a core-type resin mold as shown in Figure 9 (number of laminated layers in total: 450).
(4) A cavity-type resin mold was formed by performing the same steps as the above (1)-(3) (number of laminated layers of intermediate laminate: 100, number of laminated layers in total: 450).

Example 2

Cavity-type and core-type resin molds were fabricated in the same manner as in the Example 1 except for using the photocurable material [2] instead of the photocurable material [1].

Example 3

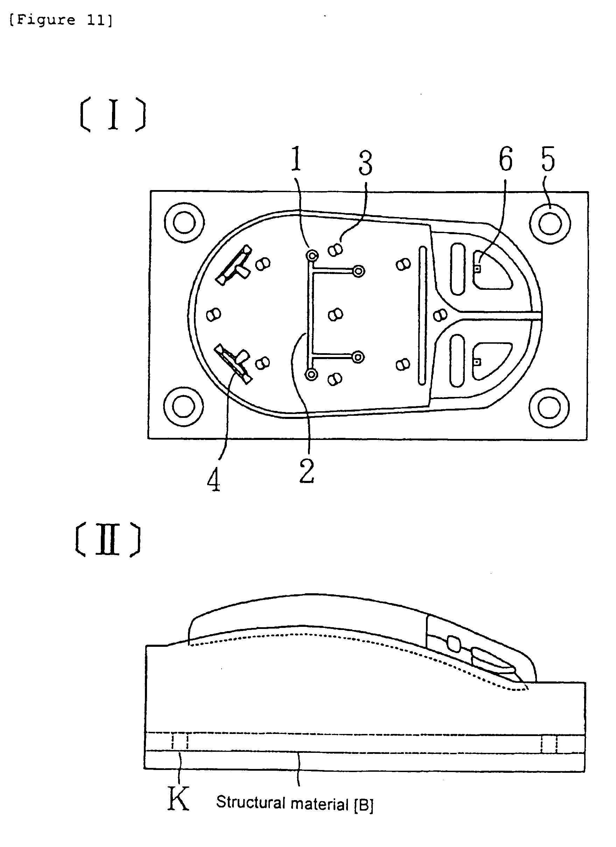

Cavity-type and core-type resin molds were fabricated in the same manner as in the Example 1 by using the photocurable material [1] and the structural material [B] as follows. Figure 11 is a plan view (I) and a side view (II) of the core-type resin mold.

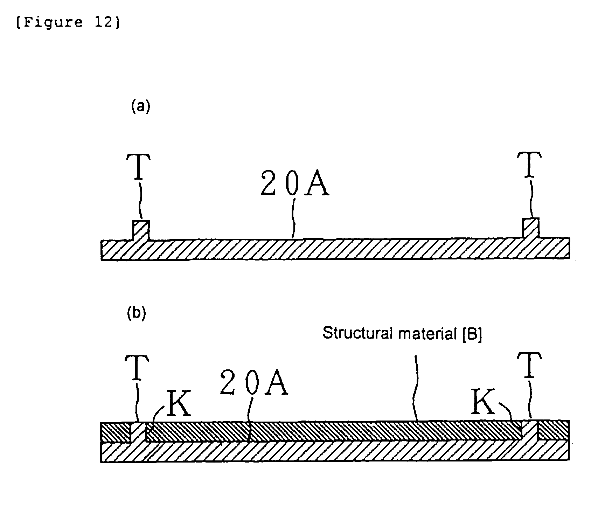

(1) As shown in Figure 12, a first resin laminate 20A (length: 200 mm, width 100 mm, height 10 mm) with cylindrical projections T (diameter: 10 mm, height: 5 mm) corresponding to through-holes K of the structural material [B] formed thereon was fabricated (number of laminated layers of primary laminate: 75).
(2) The said structural material [B] was placed on the surface of the first resin laminate 20A with the projections T engaging with the through-holes K. Here, the surface of the structural material [B] is substantially even with the surface of the projections T of the first resin laminate 20A.
(3) The step of forming a cured resin layer from the photocurable material [1] on the upper surfaces of the structural material [B] and the projections T was repeated to form a second resin laminate (number of laminated layers: 350).

The core-type resin mold as shown in Figure 11 was thus fabricated (number of laminated layers in total: 425).

(4) A cavity-type resin mold was fabricated by performing the same steps as the above (1)-(3).

Example 4

Cavity-type and core-type resin molds were fabricated in the same manner as in the Example 3 except for using the photocurable material [3] instead of the photocurable material [1].

Comparative Example 1

Cavity-type and core-type resin molds were fabricated in the same manner as in the Example 1. However, instead of using the copper plate [A], a resin laminate with a thickness of 10 mm formed from the photocurable material [1] was placed in concavity 20H.

Comparative Example 2

Cavity-type and core-type resin molds were fabricated in the same manner as in the Comparative Example 1 except for using the photocurable material [2] instead of the photocurable material [1].

Comparative example 3

Cavity-type and core-type resin molds were fabricated in the same manner as in the Comparative Example 1 except for using the photocurable material [3] instead of the photocurable material [1].

Evaluation of resin mold

Using the cavity-type and core-type resin molds obtained in the Examples 1-4 and the Comparative Examples 1-3, a molding material consisting of an acrylonitrile-butadiene-styrene resin "S996-JB Gray" (manufactured by Techno Polymer Co., Ltd.) was molded by an injection molding under the following conditions: clamping force: 10 ton, cylinder temperature: 230°C, mold temperature: 40°C, injection speed: 20 mm/second, and dwell: 175 kg/cm$^2$. Dimensional accuracy of fabricated products and durability of the resin molds in repeated use were evaluated.

Dimensional accuracy of fabricated products: The case where the dimensional deviation between the objective molding and the fabricated products obtained in Examples was less than 0.5% was rated as "good", the case where the dimensional deviation was 0.5% or more was rated as "bad".

Durability in repeated use: The number of moldings before the resin mold breaks was counted through continuous injection moldings.

The results are shown in Table 1.

[Table 1]

|  | Accuracy of fabrication | Durability |
|---|---|---|
| Example 1 | Good | 352 |
| Example 2 | Good | 280 |
| Example 3 | Good | 315 |
| Example 4 | Good | 297 |
| Comparative Example 1 | Good | 103 |
| Comparative Example 2 | Bad | 88 |
| Comparative Example 3 | No resin mold was formed | No resin mold was formed |

Both the cavity-type and the core-type resin molds obtained in the Comparative Example 3 exhibited a considerable amount of warping. Because of this, the acrylonitrile-butadiene-styrene resin exited from the parting surface in injection molding, so that no fabricated products could be fabricated.

**Claims**

1. An article comprising:

   a plurality of photofabricated cured resin layers, and at least one integral structural member, wherein the structural member has greater strenght than the cured resin layers.

2. The article of claim 1, wherein the structural member has a greater tensile strenght than the cured resin layers.

3. The article according to any one of claims 1-2, wherein the structural member material has greater flexural strenght than the cured resin layers.

4. The article according to any one of claims 1-3, wherein at least one resin layer is formed on each side of the at least one structural member.

5. The article according to any one of claims 14, wherein the at least one structural member is surrounded by cured resin layers.

6. The article according to any one of claims 1-5, wherein the article is three-dimensional.

7. The article according to any one of claims 1-6, wherein the article is a three-dimensional mold.

8. A process for manufacturing the article of any one of claims 1-7 comprising:

   A. coating a portion of a structural member with a photocurable resin material,
   B. selectively irradiating the photocurable material to form an article having a structural member with at least a portion covered with a cured resin material,
   C. further coating said article with the photocurable resin material,
   D. irradiating the further coating to selectively cure portions thereof, and
   E. repeating C and D.

9. A process for manufacturing the article of any one of claims 1-7 comprising:

   A coating a cured resin material with a photocurable resin material,
   B. selectively irradiating at least a portion of the photocurable material,
   C. repeating A and B to form a base,
   D. placing a structural member in contact with the base.
   E. coating at least a portion of the base and the structural member with the photocurable material,
   F. selectively irridiating at least a portion of the photocurable material to form an article having a structural member on the base and at least a portion covered with a cured resin material,
   G. further coating the article with the photocurable resin material,
   H. irradiating the further coating to selectively cure portions thereof, and
   I. repeating G and H.

10. The process of claim 9, wherein the base has a concave portion for receiving the structural member.

[Figure 1]

Resin laminate 20

Structural material 10

[Figure 2]

Second resin laminate 20B

Structural material 10

First resin laminate 20A

[Figure 3]

Resin laminate 20

Structural material 10

[Figure 4]

(a)

[ 1 ]

10

30

(b)

[ 2 ]

[ 1 ]

10

30

(c)

[ n ]

20

[ 2 ]

[ 1 ]

10

30

[Figure 5]

(a) [1·1]
30

(b) [1·2]
[1·1]
30

(c) [1·n]
20A
[1·2]
[1·1]
30

(d) 10
[1·n]
20A
[1·2]
[1·1]
30

(e) 10 [2·1]
20A
[1·n]
[1·2]
[1·1]
30

(f) 10 [2·1] [2·2]
20A
[1·n]
[1·2]
[1·1]
30

(g) 20B
[2·m]
[2·2]
[2·1]
10
20A
[1·n]
[1·2]
[1·1]
30

[Figure 6]

[Figure 7]

Side view

c

Plan view

b

a

[Figure 8]

Side view   K   c

Plan view   K

b

d

a

[Figure 9]

〔Ⅰ〕

1  3  6  5

4  2

〔Ⅱ〕

Structural material [A]

[Figure 10]

(a)

$2\,0\,C$          $2\,0\,H$

(b)

$2\,0\,C$          Structural material [A]

[Figure 11]

〔 I 〕

〔 II 〕

K    Structural material [B]

[Figure 12]

(a)

T    2 0A    T

(b)

Structural material [B]

T    K    2 0A    K    T